Europäisches Patentamt

European Patent Office

Office européen des brevets

(19)

(11) Publication number: **0 178 801**
A2

# (12) EUROPEAN PATENT APPLICATION

(21) Application number: **85306681.9**

(22) Date of filing: **19.09.85**

(51) Int. Cl.⁴: **H 01 L 29/10**
**H 01 L 29/72**

(30) Priority: **20.09.84 JP 197304/84**

(43) Date of publication of application:
**23.04.86 Bulletin 86/17**

(84) Designated Contracting States:
**DE FR GB NL**

(71) Applicant: **SONY CORPORATION**
**7-35 Kitashinagawa 6-Chome Shinagawa-ku**
**Tokyo 141(JP)**

(72) Inventor: **Kato, Yoji c/o Patents Division**
**Sony Corporation 6-7-35 Kitashinagawa**
**Shinagawa-ku Tokyo 141(JP)**

(72) Inventor: **Watanabe, Seiichi c/o Patents Division**
**Sony Corporation 6-7-35 Kitashinagawa**
**Shinagawa-ku Tokyo 141(JP)**

(72) Inventor: **Wada, Masaru c/o Patents Division**
**Sony Corporation 6-7-35 Kitashinagawa**
**Shinagawa-ku Tokyo 141(JP)**

(74) Representative: **Thomas, Christopher Hugo et al,**
**D Young & Co 10 Staple Inn**
**London WC1V 7RD(GB)**

(54) Semiconductor device with imaginary base region.

(57) A semiconductor device includes a semiconductor subs-
trate (11) having a semi-insulating property, a first region
(12) of one conductivity-type which will become an emitter
region, a second region (13) of the one conductivity-type
which will become a collector region, the first and second
regions (12, 13) being formed on the substrate (11) with a
predetermined spacing therebetween, and a third region (14)
of another conductity-type formed on the substrate (11)
between the first and second regions (12,13). A forward
biasing voltage is applied between the third and first regions
(14,12) thereby to form an imaginary base region (19) in the
substrate (11) beneath the third region (14) by majority
carriers implanted or injected from the third region (14),
whereby the semiconductor device carries out a bipolar
transistor operation, and at least one of the first and third
regions (12,14) consists of a plurality of regions.

FIG. 3

# SEMICONDUCTOR DEVICES

This invention relates to semiconductor devices.

A prior art bipolar transistor used as a circuit element of a semiconductor integrated circuit is formed with a so-called lateral structure, in which an emitter region, a base region and a collector region are respectively located side-by-side for ease of manufacture and simplicity of the wiring pattern. However, such a bipolar transistor generally has a current amplification factor $\beta$ .

We have previously proposed a semiconductor device which has a lateral structure and which can carry out bipolar transistor operation with a large current amplification factor $\beta$ . This is disclosed in the published specification of unexamined Japanese patent application no. 58/224841. Figures 1 and 2 of the accompanying drawings show an example of such a semiconductor device. The semiconductor device is formed such that on one major surface 1a of a semiconductor substrate 1 having a semi-insulating property, there are formed a first region 2 of, for example, $n^+$ type which will become an emitter region, a second region 3 of $n^+$ type which will become a collector region, and a third region 4 of $p^+$ type. On the first, second and third regions 2, 3 and 4, there are formed an emitter electrode 5, a collector electrode 6 and a base electrode 7, respectively. With this arrangement, when a forward biasing voltage is applied between the first and third regions 2 and 4, holes are injected with high concentration from the third region 4 into the region of the semi-insulating semiconductor substrate 1 beneath the third region 4, whereby an imaginary base region 8 is formed in this region of the substrate 1, as shown by a broken line. Electrons injected from the first region 2 can then be introduced through the imaginary base region 8 into the second region 3, which is positively biased, so that the semiconductor device operates as a bipolar transistor of n-p-n type.

According to the present invention there is provided a semiconductor device comprising:

a semiconductor substrate having a semi-insulating property;

a first region of one conductivity-type which will become an emitter region;

a second region of said one conductivity-type which will become a collector region, said first and second regions being formed on said substrate with a predetermined spacing therebetween;

a third region of another conductivity-type formed on said substrate between said first and second regions; and

means for applying a forward biasing voltage between said third and first regions to form an imaginary base region in said substrate beneath said third region by majority carriers implanted or injected from said third region, whereby said semiconductor device can operate as a bipolar transistor; characterised in that:

at least one of said first and said third regions consists of a plurality of regions.

The invention will now be described by way of example with reference to the accompanying drawings, throughout which like parts are referred to by like references, and in which:

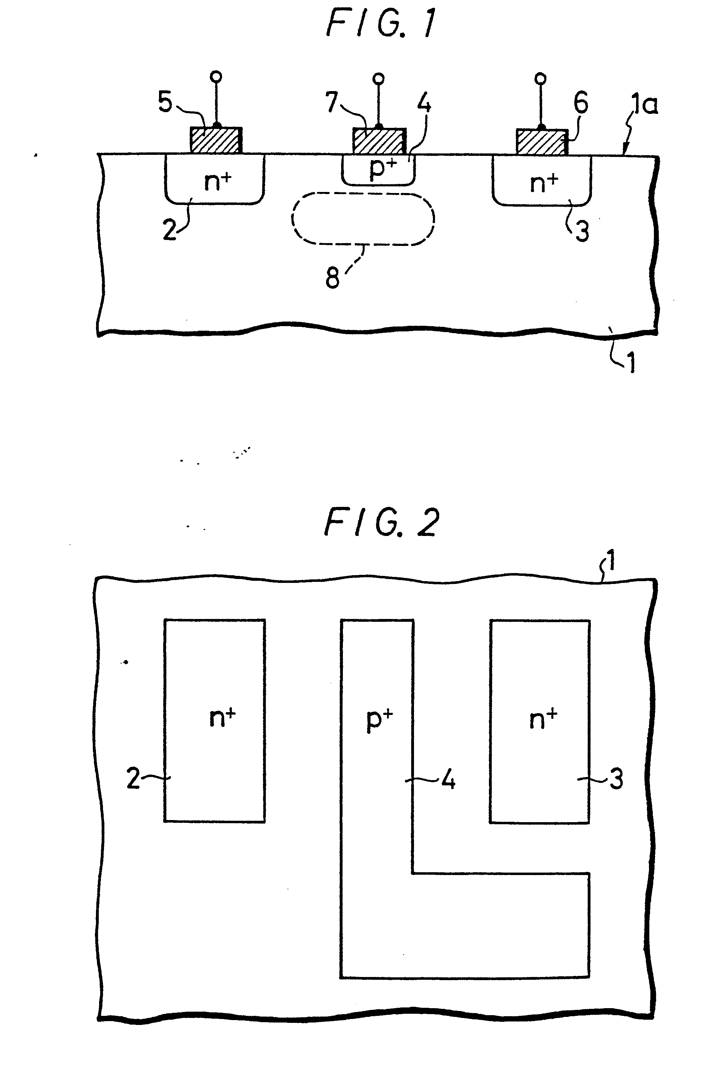

Figures 1 and 2 are respectively an enlarged cross-sectional view and a plan view of a previously proposed semiconductor device;

Figure 3 is an enlarged cross-sectional view of a first embodiment of semiconductor device according to the present invention;

Figure 4 is a plan view of the first embodiment; and

Figures 5 and 6 are plan views of second and third embodiments of semiconductor device according to the present invention.

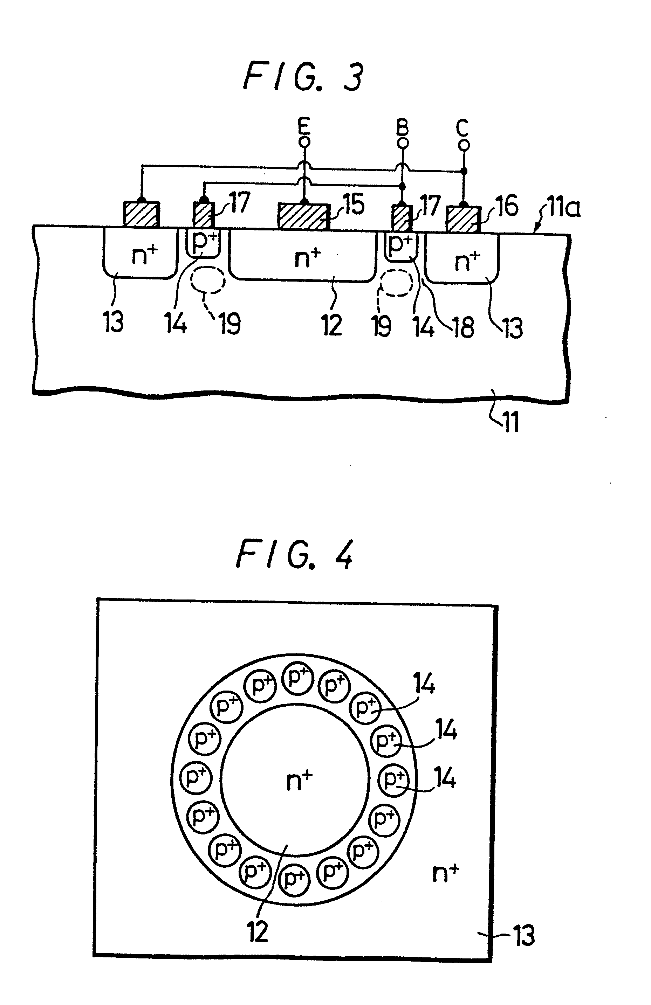

The first embodiment will now be described with reference to Figures 3 and 4. In this embodiment, there is provided a III-V compound semiconductor substrate such as GaAs substrate or semiconductor layer 11 having a semi-insulating property, which is very low in current carrier concentration and which presents a high resistance, for example, of $10^6$ ohm cm. On one major surface 11a of the semiconductor layer 11 and in facing relation to the major surface 11a, there are respectively formed a first region 12 of, for example, n-type having a high impurity concentration, which will become an emitter region, and a second region 13 of n-type with high impurity concentration, which will become a collector region. The second region 13 surrounds and is spaced from the first region 12 by a predetermined distance, and is formed, for example, by an ion implantation method or a diffusing method. In this case, the first region 12 has a circular shape as seen in Figure 4. Then, between the first and second regions 12 and

3

0178801

13, a plurality of third regions 14 of, for example, p-type having a high impurity concentration are formed. The third regions 14 encircle the first region 12, and are formed, for example, by an ion implantation method or a diffusing method, in such a manner that the third regions 14 have smaller depths than the regions 12 and 13. On the first, second and third regions 12, 13 and 14, there are deposited an emitter electrode 15, a collector electrode 16 and a base electrode 17, respectively, in ohmic contact therewith. The base electrode 17 is formed common to all the third regions 14 or independently on each of them, as desired. An emitter terminal E, a collector terminal C and a base terminal B are connected to the electrodes 15, 16 and 17, respectively.

Then, a forward biasing voltage is applied between the first and third regions 12 and 14, while a reverse biasing voltage is applied between the third and second regions 14 and 13, respectively. Accordingly, holes as the majority carrier from the third regions 14 are injected into a high resistance region 18, which is formed in the semi-insulating semiconductor substrate 11 beaneath the third regions 14, and between the first region 12 and the second region 13, thereby forming an imaginary base region 19. Due to the imaginary base region 19, the injection of the electrons as the majority carriers from the first region 12 is prompted, and the injected electrons pass through the imaginary base region 19 to the second region 13, so the semiconductor device of this embodiment can operate as an n-p-n bipolar transistor of lateral structure.

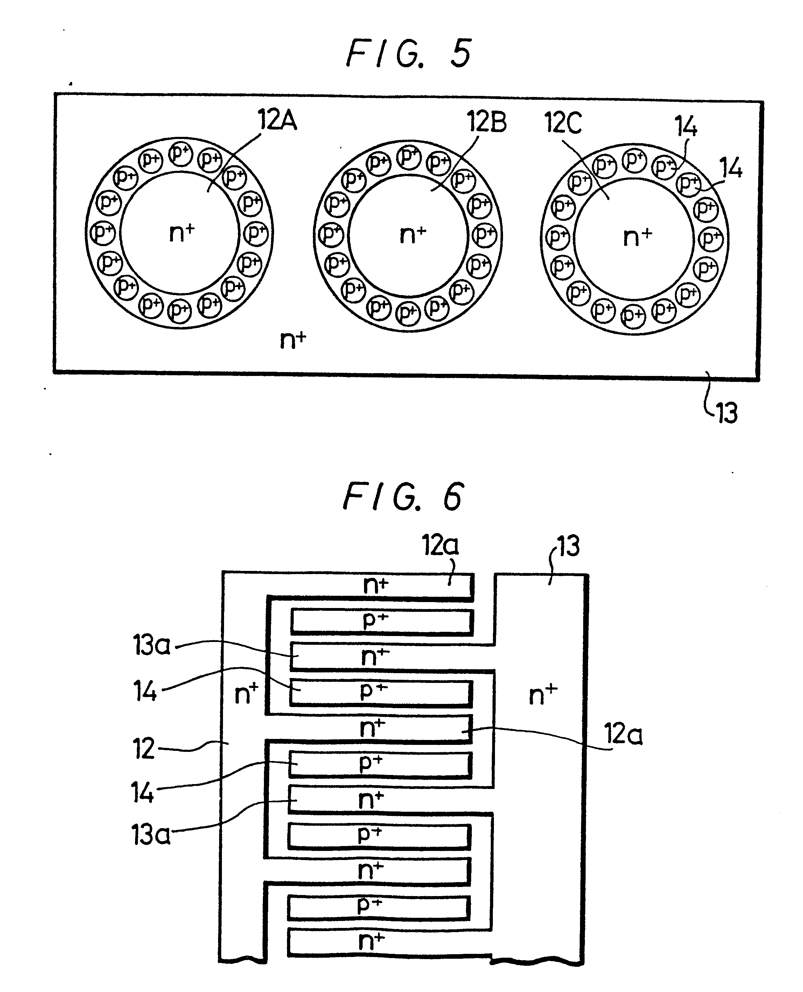

Figure 5 is a plan view showing the second embodiment of semiconductor device according to the present invention. As shown in Figure 5, there are provided a plurality of first regions 12 (12A, 12B and 12C) which will become emitter regions, and a second region 13 which will become a common collector region 13 surrounds the first regions 12. Between each first region 12 and the second region 13, there are respectively provided a plurality of third regions 14 so as to encircle each first region 12.

Figure 6 is a plan view showing the third embodiment of semiconductor device according to this invention. As shown in Figure 6, a first region 12 of a so-called comb-shape which is formed by connecting one end of each of a plurality of parallel regions 12a and which will become an emitter region, and a second region 13 of a comb-shape which is formed by connecting one end of each of a plurality of parallel regions 13a, and which will become a collector region, are respectively disposed such that the parallel regions 12a and the parallel regions 13a are located alternately with one another. Then, a respective third region 14 is formed between the first and second regions 12a and 13a.

With semiconductor devices as described above, although they are of lateral structure, there is the advantage that the current amplification factor $\beta$ thereof can be increased. That is, since the base region, or the current path formed by the implanted or injected carriers, is formed in the semi-insulating region 18 outside the third region 14 having the high impurity concentration, the diffusion length of the injected carriers is extremely long. Moreover, there is little effect on the injected carriers by the portion of the semiconductor surface where the re-combination rate is large, and the injected carriers do not flow through the third region 14 but flow through a portion of the semi-insulating region 18 where the potential barrier is low and flat, which portion is little affected by the collector voltage. Thus, the semiconductor device can carry out the bipolar transistor function with a large current amplification factor $\beta$.

Also, when the semiconductor device is formed by using a compound semiconductor, it is possible to obtain a semiconductor device capable of operating at higher speed.

Since the effective base region is formed in the semi-insulating semiconductor, the characteristics of such semiconductor devices are little affected by the depths of the third regions, or the scatter of characteristics. Thus, it is easily possible to manufacture a semiconductor device whose characteristics are stable and uniform.

Moreover, since the semiconductor device has a lateral structure, it is easy to lead out electrode terminals and to carry out the wiring thereof. Hence, the semiconductor device is advantageous when forming an integrated circuit.

Furthermore, since the semiconductor device is formed on the semi-insulating semiconductor, when the semiconductor device is used in an integrated circuit, there is the advantage that the isolation between the circuit elements can be simplified.

In embodiments of the semiconductor device, particularly as shown in Figures 4, 5 and 6, the plurality of third regions 14 are provided so as to encircle the first region 12, or a plurality of first regions 12 are provided and a plurality of third regions 14 are provided so as to encircle each first region 12. That is, a plurality of each of the first regions 12, the second regions 13 and the third regions 14 can be provided. Accordingly, even if the semiconductor apparatus is used for high output operation, it can be prevented from being damaged, so it is possible to make a semiconductor device which is suitable for high output and high frequency operation. In addition, the semiconductor device is very suitable not only in a case where it is used alone, but also a case in which it is used as a circuit element of a integrated circuit at a position where, for example, the fan in or fan out is large.

## CLAIMS

1.    A semiconductor device comprising:

a semiconductor substrate (11) having a semi-insulating property;

a first region (12) of one conductivity-type which will become an emitter region;

a second region (13) of said one conductivity-type which will become a collector region, said first and second regions (12, 13) being formed on said substrate (11) with a predetermined spacing therebetween;

a third region (14) of another conductivity-type formed on said substrate (11) between said first and second regions (12, 13); and

means for applying a forward biasing voltage between said third and first regions (14, 12) to form an imaginary base region (19) in said substrate (11) beneath said third region (14) by majority carriers implanted or injected from said third region (14), whereby said semiconductor device can operate as a bipolar transistor;

characterised in that:

at least one of said first and said third regions (12, 14) consists of a plurality of regions.

2.    A semiconductor device according to claim 1 wherein said first region (12) is circular, a plurality of discrete said third regions (14) encircle said first region (12), and said second region (13) surrounds said first and third regions (12, 14).

3.    A semiconductor device according to claim 1 wherein said first and second regions (12, 13) are each comb-shaped comprising parallel-extending elongated teeth portions (12a, 13a) in over-lapping alternating relation, and a respective discrete elongated said third region (14) is disposed between each adjacent pair of said teeth portions (12a, 13a).

0178801

## FIG. 1

## FIG. 2

0178801

## FIG. 3

## FIG. 4

## FIG. 5

## FIG. 6